# EUROPÄISCHE PATENTSCHRIFT

(11) **EP 0 534 134 B1**
(45) Veröffentlichungstag und Bekanntmachung des Hinweises auf die Patenterteilung: **16.10.1996**
(21) Anmeldenummer: 92114207.1
(22) Anmeldetag: 20.08.1992
(51) Int. Cl.: H03F 3/50

(54) **Verstärkerschaltung mit Bipolar- und Feldeffekt-Transistoren**
Amplifier circuit with bipolar and field effect transistors
Circuit d'amplification avec transistors bipolaires et transistors à effet de champ

(30) Priorität: 27.09.1991 DE 4132219
(43) Veröffentlichungstag der Anmeldung: 31.03.1993
(73) Patentinhaber: Alcatel SEL Aktiengesellschaft, D-70435 Stuttgart (DE); ALCATEL N.V., NL-1077 XX Amsterdam (NL)
(72) Erfinder: Schnabel, Jürgen, W-7129 Ilsfeld (DE)
(74) Vertreter: Hösch, Günther, Dipl.-Ing.

(56) Entgegenhaltungen:
- DE-A- 2 816 314
- GB-A- 2 219 162
- US-A- 5 012 134

## Beschreibung

Die vorliegende Erfindung betrifft eine Verstärkerschaltung gemäß dem Oberbegriff des Anspruchs 1.

Ein derartiger Verstärker ist beispielsweise aus dem Fachbuch "FETs und VMOs" von S. Wirsum, Franzis' Verlag, ISBN 3-7723-6741-0, Seiten 90 und 91 bekannt. Bei diesem dort beschriebenen aus diskreten Bauelementen aufgebauten vierstufigen Operationsverstärker sind in der Differenzverstärker-Eingangsstufe Feldeffekttransistoren vorgesehen. Die Transistoren der übrigen Stufen sind Bipolartransistoren. Hierdurch erhält man eine sehr hohe Eingangsimpedanz, einen niedrigen Eingangsstrom und geringes Eingangsrauschen, insbesondere bei höheren Frequenzen oder hohen Quellimpedanzen.

Aus dem Buch "Halbleiter-Schaltungstechnik" von U. Tietze und Ch. Schenk, achte Auflage, Springer-Verlag, 1986, Seiten 142 und 143 ist es außerdem bekannt, bei monolithisch integrierten Operationsverstärkern nur die Eingangsstufe aus Sperrschicht-Feldeffekttransistoren (Bifet-Technologie) oder aus MOS-Feldeffekttransistoren (Bimos-Technologie) oder den ganzen Operationsverstärker ausschließlich aus MOSFETs aufzubauen (CMOS-Technologie).

Weiterhin ist ein FET-Source-Folger mit wenigstens einem FET bekannt, bei dem ein Widerstand zwischen den Gate-Anschluß des FET und einer Signalquelle geschaltet ist, vgl. DE-A-28 16 314. Der Widerstand ist so bestimmt, daß eine Schwingung des FET verhindert wird.

Eingangsstufen mit Feldeffekttransistoren haben zwar einen extrem hohen Eingangswiderstand und benötigen nur einen verschwindend geringen Eingangsstrom, wodurch auch der Eingangsoffsetstrom praktisch vernachslässigbar wird; sie sind jedoch gegenüber bipolaren Eingangsstufen bezüglich der Eingangsoffsetspannung sowie bezüglich der Rauschspannung bei niedrigen Frequenzen im Nachteil. Außerdem ist die Steilheit von bipolaren Transistoren höher, wodurch eine höhere Spannungsverstärkung möglich wird.

Mit der vorliegenden Erfindung soll die Aufgabe gelöst werden, eine Schaltung für einen Verstärker, insbesondere einen Operationsverstärker anzugeben, die bei kleinen Eingangsströmen eine sehr hohe Verstärkung des Eingangssignals bewirkt und gleichzeitig die Offsetspannungsdrift nach Möglichkeit nicht zu erhöhen sondern gegebenenfalls sogar zu verringern.

Gelöst wird diese Aufgabe durch die im Anspruch 1 angegebenen Merkmale. Durch den wegen des in Drainschaltung betriebenen MOSFETs sehr hohen Eingangswiderstand von z.B. >10¹²Ω der Zwischenstufe wird die Eingangsstufe gleichstrommäßig überhaupt nicht belastet, und zwar auch dann nicht, wenn die Endstufe einen niedrigen Eingangswiderstand besitzt. Mit der Eingangsstufe sind daher sehr hohe Gleichspannungs-Verstärkungsfaktoren bei gleichzeitig vergleichsweise niedrigen Ruheströmen erreichbar, wodurch einerseits die Gleichspannungs-Gesamtverstärkung vergrößert, andererseits die Eingangs-Bias- und -Offsetströme reduziert werden.

Durch Verwendung eines weiteren, dem genannten MOSFET nachgeschalteten und in Widerstandsschaltung betriebenen MOSFET erhält man als Zwischenstufe einen nahezu idealen Spannungsfolger. Ebenso wird die effektive Offset-Spannung am Eingang, welche bei Verwendung von Bipolartransistoren in der ersten Stufe ohnehin wesentlich günstiger liegt als beim Einsatz von Feldeffekttransistoren, durch die höhere Verstärkung der ersten Stufe, welche Offseteinflüsse nachfolgender Stufen reduziert, sowie durch andere Effekte zusätzlich verringert.

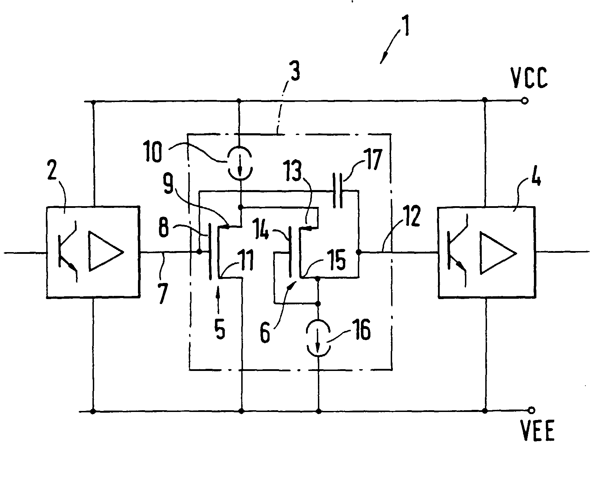

Weitere vorteilhafte Einzelheiten der Erfindung sind in den Unteransprüchen angegeben und nachfolgend anhand eines in der Zeichnung veranschaulichten Schaltungsbeispiels beschrieben.

Die Verstärkerschaltung 1 ist ein dreistufiger Verstärker mit einer Eingangsstufe 2, einer Zwischenstufe 3 und einer Endstufe 4. Die Eingangsstufe 2 und die Endstufe 4 sind mit in Bipolar-Technologie hergestellten Transistoren beschaltet, wie durch das jeweils eingezeichnete Transistorsymbol angedeutet ist.

Die Zwischenstufe 3 ist mit in MOS-Technologie hergestellten Feldeffekttransistoren 5 und 6 aufgebaut. Ein Ausgang 7 der Eingangsstufe 2 ist mit einem Gate 8 des in Drainschaltung betriebenen MOSFET 5 verbunden. Eine Source-Elektrode 9 desselben ist über eine Konstantstromquelle 10 mit der Betriebsspannung VCC und seine Drain-Elektrode 11 mit Erdpotential VEE verbunden. Hierdurch besitzt die Zwischenstufe 3 für niedrige Frequenzen und Gleichstrom einen nahezu unendlich großen Eingangswiderstand, so daß die Eingangsstufe 2 gleichstrommäßig überhaupt nicht belastet wird, selbst wenn die am Ausgang 12 der Zwischenstufe 3 angeschlossene Stufe, hier die Endstufe 4, einen sehr niedrigen Eingangswiderstand besitzt. Die Eingangsstufe 2 kann daher einen sehr hohen Verstärkungsfaktor erreichen, was zu hoher Gleichspannungs-Gesamtverstärkung bei gleichzeitig kleinen Offsetströmen und Offsetspannungen, z.B. durch Temperaturdrift etc., führt.

Zweckmäßig ist dem in Drainschaltung betriebenen MOSFET 5 der vorzugsweise in Widerstandsschaltung betriebene zweite MOSFET 6 nachgeschaltet Dessen Source-Elektrode 13 ist mit der Source-Elektrode 9 des ersten MOSFET 5 verbunden und seine Gate-Elektrode 14 sowie die Drain-Elektrode 15 sind miteinander verbunden und über eine Konstantstromquelle 16 auf Erdpotential VEE gelegt. Hierdurch erhält man am Ausgang 12 eine Potentialverschiebung gegenüber der an den Source-Elektroden 9 und 13 anstehenden Spannung und die Zwischenstufe 3 wirkt als nahezu idealer Spannungsfolger. Der durch die unterschiedlichen Drain-Source-Spannungen der beiden MOSFET 5 und 6 auftretende sehr geringe Fehler führt zwar zu einer geringen Offsetspannung, die sich jedoch nur durch den hohen Verstärkungsfaktor der Eingangsstufe 2 geteilt am Eingang auswirkt (Offsetspannung am Eingang = Offsetspannung der Schaltung: Verstärkung bis zu dieser Stelle). Entsprechend reduzieren sich auch die Auswirkungen von Streuungen und Toleranzen in den nachfolgenden Stufen (Endstufe 4) um den erreichten Verstärkungsgewinn, so daß insgesamt eine Verringerung der effektiven Offsetspannung am Eingang erreicht wird.

Noch drastischer können der BIAS- und Offsetstrom am Eingang reduziert werden. Durch die gleichstrommäßige Entkopplung der Eingangsstufe 2 kann diese mit einem wesentlich geringeren Strom betrieben werden, wodurch sich auch die Basisströme der Transistoren der Eingangsstufe 2 und damit die Eingangsströme entsprechend skalieren. Mit Feldeffekttransistoren in der Eingangsstufe 2 sind zwar noch geringere Eingangsstöme realisierbar, diese haben aber, physikalisch bedingt, auch wesentlich höhere Offsetspannungen und ein größeres Rauschen bei niedrigen Frequenzen (1/f-Rauschen).

Zur Verhinderung zusätzlicher Phasendrehungen entlang der Zwischenstufe 3 kann ein Kondensator 17 zwischen der Gate-Elektrode 8 des MOSFET 5 und der Drain-Eldektrode 15 des MOSFET 6 angeschlossen sein. Dieser schließt den Eingang 7 und den Ausgang 12 der Zwischenstufe 3 für höhere Frequenzen kurz. Die Kapazität des Kondensators 17 bewegt sich im Bereich von einigen Pikofarad.

Anstelle des beschriebenen dreistufigen Verstärkers kann auch ein mehrstufiger Verstärker vorgesehen sein, wobei in einer Zwischenstufe Transistoren in MOSFET-Technologie eingesetzt werden, jedoch vorherige und nachfolgende Stufen in Bipolartechnologie aufgebaut werden.

Die erfindungsgemäße Schaltung ermöglicht eine nahezu ideale Verbindung der Vorteile der Bipolar-Technologie nämlich hohe Steilheit, geringe Offsetspannung, geringes 1/f-Rauschen, mit den Vorteilen der MOS-Technologie, nämlich extrem hoher Eingangswiderstand. Beide Technologien sind bei der Herstellung der Schaltung auf einem Halbleitersubstrat nebeneinander in sogenannter BICMOS-Technologie anwendbar. Gleichzeitig kann auch der Kondensator 17 nach einer der an sich bekannten Methoden auf dem gleichen Halbleitersubstrat erzeugt werden.

## Patentansprüche

1. Verstärkerschaltung (1), die sowohl Transistoren in Bipolartechnik als auch Feldeffekt-Transistoren in MOS-Technik aufweist, mit einer Eingangsstufe (2), wenigstens einer Zwischenstufe (3) und einer Endstufe (4), insbesondere für Operationsverstärker,
**dadurch gekennzeichnet,** daß sowohl sowohl die Eingangsstufe (2) als auch die Endstufe (4), zum Erzielen der für die Bipolartechnik typischen Eigenschaften, wie hohe Steilheit, geringe Offsetspannung, geringes 1/f- Rauschen, mindestens einen Transistor in Bipolartechnik enthält, daß in der wenigstens einen Zwischenstufe (3) ein in Drainschaltung betriebener MOS-Feldeffekttransistor (5) vorgesehen ist, dessen Gate-Elektrode (8) mit dem Ausgang (7) der Eingangsstufe (2) verbunden ist und daß der Ausgang (12) wenigstens einer Zwischenstufe (3) mit dem Eingang der Endstufe (4) verbunden ist.

2. Verstärkerschaltung nach Anspruch 1, dadurch gekennzeichnet, daß sie auf einem gemeinsamen Halbleitersubstrat durch Anwendung der Bipolar- und der MOS-Technik (BICMOS-Technologie) hergestellt ist.

3. Verstärkerschaltung nach Anspruch 1 oder 2, dadurch gekennzeichnet, daß dem MOS-Feldeffekttransistor (5) ein in Widerstandsschaltung betriebener weiterer Feldeffekttransistor (6) gleichen Typs nachgeschaltet ist.

4. Verstärkerschaltung nach Anspruch 3, dadurch gekennzeichnet, daß eine Source-Elektrode (13) des weiteren Feldeffekttransistors (6) mit einer Source-Elektrode (9) des MOS-Feldeffekttransistors (5) und die Drain- und Gate-Elektroden (15 und 14) des weiteren Feldeffekttransistors (6) mit einem Eingang der nachfolgenden Stufe (4) verbunden sind.

5. Verstärkerschaltung nach Anspruch 4, dadurch gekennzeichnet, daß die Source-Elektrode (9) des MOS-Feldeffekttransistors (5) oder die Source-Elektroden (9, 13) beider Feldeffekttransistoren (5, 6) über eine Konstantstromquelle (10) mit einem Pol (VCC) der Betriebsspannung verbunden ist bzw. sind.

6. Verstärkerschaltung nach Anspruch 3, dadurch gekennzeichnet, daß die Gate- und Drain-Elektroden (14 und 15) des weiteren Feldeffekttransistors (6) über eine Konstantstromquelle (16) mit einem anderen Pol (VEE) der Betriebsspannung verbunden sind.

7. Verstärkerschaltung nach einem der Ansprüche 1 bis 6, dadurch gekennzeichnet, daß die Gate-Elektrode (8) des ersten MOS-Feldeffekttransistors (5) über einen Kondensator (17) mit einem Ausgang (12) der Zwischenstufe (3) verbunden ist.

8. Verstärkerschaltung nach Anspruch 7, dadurch gekennzeichnet, daß der Kondensator (17) auf dem Halbleitersubstrat erzeugt ist.

## Claims

1. Amplifier circuit (1) comprising both bipolar and MOS field-effect transistors, having an input stage (2), at least one intermediate stage (3), and an output stage (4), in particular for operational amplifiers,
**characterised in that**
in order to achieve the typical characteristics of bipolar technology, such as high transconductance, low offset voltage, low 1/f noise, both the input stage (2) and the output stage (4) contain at least one bipolar transistor, and that the at least one intermediate stage (3) includes a MOS field-effect transistor (5) operated in the common drain mode, whose gate electrode (8) is connected to the output (7) of the input stage (2), and that the output (12) of at least one intermediate stage (3) is connected to the input of the output stage (4).

2. Amplifier circuit according to Claim 1, **characterised in that** it is produced on a common semiconductor substrate by using bipolar technology and MOS technology (BICMOS technology).

3. Amplifier circuit according to Claim 1 or 2, **characterised in that** an additional field-effect transistor (6) of the same type and operated as a resistor is connected downstream of the MOS field-effect transistor (5).

4. Amplifier circuit according to Claim 3, **characterised in that** a source electrode (13) of the additional field-effect transistor (6) is connected to a source electrode (9) of the MOS field-effect transistor (5) and that the drain and gate electrodes (15 and 14) of the additional field-effect transistor (6) are connected to an input of the following stage (4).

5. Amplifier circuit according to Claim 4, **characterised in that** the source electrode (9) of the MOS field-effect transistor (5) or the source electrodes (9, 13) of both field-effect transistors (5, 6) are connected via a constant-current source (10) to one terminal (VCC) of the supply voltage source.

6. Amplifier circuit according to Claim 3, **characterised in that** the gate and drain electrodes (14 and 15) of the additional field-effect transistor (6) are connected via a constant-current source to another terminal (VEE) of the supply voltage source.

7. Amplifier circuit according to any one of Claims 1 to 6, **characterized in that** the gate electrode (8) of the first MOS field-effect transistor (5) is connected via a capacitor (17) to an output (12) of the intermediate stage (3).

8. Amplifier circuit according to Claim 7, **characterised in that** the capacitor (17) is produced on the semiconductor substrate.

## Revendications

1. Circuit amplificateur (1) comportant des transistors en technique bipolaire mais également des transistors à effet de champ en technique MOS, comprenant un étage d'entrée (2), au moins un étage intermédiaire (3) et un étage terminal (4), en particulier pour un amplificateur opérationnel, caractérisé en ce que l'étage d'entrée (2), mais également l'étage terminal (4) comportent au moins un transistor en technique bipolaire pour obtenir les propriétés typiques de la technique bipolaire, telles que forte pente, faible tension d'offset, faible bruit en 1/f, en ce qu'on prévoit dans l'étage intermédiaire (3), au nombre d'au moins un, un transistor à effet de champ MOS (5) exploité en drain commun dont l'électrode de grille (8) est reliée à la sortie (7) de l'étage d'entrée (2), et en ce que la sortie (12) d'au moins un étage intermédiaire (3) est reliée à l'entrée de l'étage terminal (4).

2. Circuit amplificateur suivant la revendication 1, caractérisé en ce qu'il est fabriqué sur un substrat semiconducteur commun par l'utilisation des techniques bipolaire et MOS (technologie BICMOS).

3. Circuit amplificateur suivant la revendication 1 ou 2, caractérisé en ce qu'en aval du transistor à effet de champ MOS (5) est monté un transistor à effet de champ (6) du même type, exploité comme circuit de résistance.

4. Circuit amplificateur suivant la revendication 3, caractérisé en ce qu'une électrode de source (13) de l'autre transistor à effet de champ (6) est reliée à une électrode de source (9) du transistor à effet de champ MOS (5) et en ce que les électrodes de drain et de grille (15 et 14) de l'autre transistor à effet de champ (6) sont reliées à une entrée de l'étage suivant (4).

5. Circuit amplificateur suivant la revendication 4, caractérisé en ce que l'électrode de source (9) du transistor à effet de champ MOS (5) ou les électrodes de sources (9, 13) des deux transistors à effet de champ (5, 6) est/sont reliée(s) par l'intermédiaire d'une source de courant constant (10) à un pôle (VCC) de la tension de service.

6. Circuit amplificateur suivant la revendication 3, caractérisé en ce que les électrodes de grille et de drain (14 et 15) de l'autre transistor à effet de champ (6) sont reliées par l'intermédiaire d'une source de courant constant (16) à un autre pôle (VEE) de la tension de service.

7. Circuit amplificateur suivant l'une des revendications 1 à 6, caractérisé en ce que l'électrode de grille (8) du premier transistor à effet de champ MOS (5) est reliée à une sortie (12) de l'étage intermédiaire (3) par l'intermédiaire d'un condensateur (17).

8. Circuit amplificateur suivant la revendication 7, caractérisé en ce que le condensateur (17) est fabriqué sur un substrat semiconducteur.
